# EUROPEAN PATENT APPLICATION

(11) **EP 4 376 036 A1**
(43) Date of publication of application: **29.05.2024**
(21) Application number: 23168727.8
(22) Date of filing: 19.04.2023
(51) Int. Cl.: H01G 4/12, H01G 4/30, C04B 35/468, C04B 35/465, C04B 35/47, H01G 4/008, H01G 4/012, H01G 4/232

(54) **MULTILAYER ELECTRONIC COMPONENT**

(30) Priority: 22.11.2022 KR 20220157400
(71) Applicant: Samsung Electro-Mechanics Co., Ltd., Suwon-si, Gyeonggi-do (KR)
(72) Inventor: Lee, Seung Yong, Suwon-si, Gyeonggi-do (KR); Seo, Dong Chan, Suwon-si, Gyeonggi-do (KR); Lee, Yong Hwa, Suwon-si, Gyeonggi-do (KR); Park, Sang Jin, Suwon-si, Gyeonggi-do (KR); Shin, Jin Bok, Suwon-si, Gyeonggi-do (KR)
(74) Representative: Grünecker Patent- und Rechtsanwälte PartG mbB

(57) **Abstract**

A multilayer electronic component includes: a body including a dielectric layer and an internal electrode; and an external electrode disposed outside the body and connected to the internal electrode, in which the dielectric layer includes a plurality of dielectric crystal grains, and at least one of the plurality of dielectric crystal grains includes a core-shell structure including an inner core area and a shell area covering at least a portion of the core area, and 90% or more of the plurality of dielectric crystal grains satisfy an average size of 170.0 nm to 190.0 nm, and a maximum deviation of sizes of the dielectric crystal grains satisfies ± 60.0 nm compared to an average size of the dielectric crystal grains.

## Description

### CROSS-REFERENCE TO RELATED APPLICATION(S)

This application claims benefit of priority to Korean Patent Application No. 10-2022-0157400 filed on November 22, 2022 in the Korean Intellectual Property Office, the disclosure of which is incorporated herein by reference in its entirety.

### TECHNICAL FIELD

The present inventive concept relates to a multilayer electronic component.

### BACKGROUND

A multilayer ceramic capacitor, one of multilayer electronic components, is a chip-type condenser mounted on printed circuit boards of several electronic products such as an image apparatus, for example, a liquid crystal display (LCD), a plasma display panel (PDP), or the like, a computer, a smartphone, a cellular phone, and the like, to serve to charge or discharge electricity therein or therefrom.

The multilayer ceramic capacitor may be used as components of various electronic apparatuses since it has a small size, ensures a high capacitance, and may be easily mounted. As various electronic devices such as computers and mobile devices become smaller and higher in power, the demand for miniaturization and higher capacity of multilayer ceramic capacitors is increasing.

Meanwhile, one of the methods for improving the reliability of multilayer ceramic capacitors is to form dielectric crystal grains having a uniform size. However, dielectric powder and additive particles need to be uniformly dispersed to implement dielectric crystal grains having a uniform size. To this end, various methods such as using an organic dispersant in an organic solvent or coating dielectric powder with an additive have been tried.

### SUMMARY

An aspect of the present disclosure may form dielectric crystal grains having a uniform size after adsorbing additives in the form of elements or ions into dielectric particles and firing the additives.

An aspect of the present disclosure may reduce dispersion of electrical characteristics by uniformly dissolving and diffusing sub-components in dielectric particles as a whole by adding additives in an ionic state.

An aspect of the present disclosure may improve reliability of a multilayer electronic component by forming all crystal grains to have a uniform size.

An aspect of the present disclosure may improve electrical characteristics by diffusing sub-components into a core in fine-sized crystal grains having a core-shell structure.

However, various problems to be solved by the present disclosure are not limited to the above description, and may be more easily understood in the course of describing the specific exemplary embodiments of the present disclosure.

According to an aspect of the present disclosure, a multilayer electronic component may include: a body including a dielectric layer and an internal electrode; and an external electrode disposed outside the body and connected to the internal electrode, in which the dielectric layer includes a plurality of dielectric crystal grains, and at least one of the plurality of dielectric crystal grains includes a core-shell structure including an inner core area and a shell area covering at least a portion of the core area, and 90% or more of the plurality of dielectric crystal grains satisfy an average size of 170.0 nm to 190.0 nm, and a maximum deviation of a size of the dielectric crystal grain satisfies ± 60.0 nm compared to an average size of the dielectric crystal grain.

According to another aspect of the present disclosure, a multilayer electronic component may include: a body including a dielectric layer and an internal electrode; and an external electrode disposed outside the body and connected to the internal electrode, in which the dielectric layer includes a plurality of dielectric crystal grains, and at least one of the plurality of dielectric crystal grains includes a core-shell structure including an inner core area and a shell area covering at least a portion of the core area, the dielectric layer includes a main component of base material and a sub-component including a rare earth element, and the shell area and the core area of the dielectric crystal grain includes the rare earth element, and an average content of the rare earth element is higher in the shell area than in the core area.

According to still another aspect of the present disclosure, a multilayer electronic component may include: a body including a dielectric layer and an internal electrode; and an external electrode disposed outside the body and connected to the internal electrode, in which the dielectric layer includes a plurality of dielectric crystal grains, and at least one of the plurality of dielectric crystal grains includes a core-shell structure including an inner core area and a shell area covering at least a portion of the core area, and an average content of a rare earth element included in an area from a center point of the core area to a 1/2 point of the core area outward from the center point is greater than 0.00 at% and less than 0.20 at%.

### BRIEF DESCRIPTION OF DRAWINGS

The above and other aspects, features, and advantages of the present disclosure will be more clearly understood from the following detailed description taken in conjunction with the accompanying drawings, in which:
FIG. 1 is a perspective view schematically illustrating a multilayer electronic component according to an exemplary embodiment in the present disclosure;
FIG. 2 is an exploded perspective view schematically illustrating a stack structure of internal electrodes in FIG. 1;
FIG. 3 is a cross-sectional view taken along line I-I' of FIG. 1;
FIGS. 4A, 4B, and 4C are diagrams schematically illustrating dielectric powder particles of Comparative Examples and Inventive Examples;
FIG. 5 is a diagram schematically illustrating area P of FIG. 3;
FIGS. 6A, 6B, and 6C are picture images obtained by scanning dielectric layers of Comparative Examples and Inventive Examples including dielectric crystal grains with SEM;
FIGS. 7A, 7B, and 7C are picture images obtained by scanning dielectric crystal grains of Comparative Examples and Inventive Examples with TEM;
FIG. 8A, 8B, and 8C are picture images obtained by mapping Dy included in the dielectric crystal grains of FIGS. 6A to 6C with TEM-EDS; and
FIG. 9 is a graph cumulatively illustrating the number according to a failure time when MTTF evaluation is performed on a plurality of chips of Comparative Examples and Inventive Examples.

### DETAILED DESCRIPTION

Hereinafter, exemplary embodiments will be described in detail with reference to the accompanying drawings. However, exemplary embodiments may be modified in various other forms, and the scope of the present disclosure is not limited to exemplary embodiments to be described below. Further, exemplary embodiments are provided in order to more completely explain the present disclosure to those skilled in the art. In the drawings, the shapes and dimensions may be exaggerated for clarity, and the same reference numerals will be used throughout to designate the same or like components.

In order to clearly explain the present disclosure, parts irrelevant to the description will be omitted in the drawings, and sizes and thicknesses of each component illustrated in the drawings are arbitrarily indicated for convenience of description, and therefore, the present disclosure is not necessarily limited to those illustrated. Further, like reference numerals will be used to designate like components having similar functions throughout the drawings within the scope of the present disclosure. Furthermore, throughout the present specification, unless explicitly described to the contrary, "comprising" any components will be understood to imply the inclusion of other elements rather than the exclusion of any other elements.

In the drawings, a first direction may be defined as a stacking direction or a thickness (T) direction, a second direction may be defined as a length (L) direction, and a third direction may be defined as a width (W) direction.

### Multilayer Electronic Component

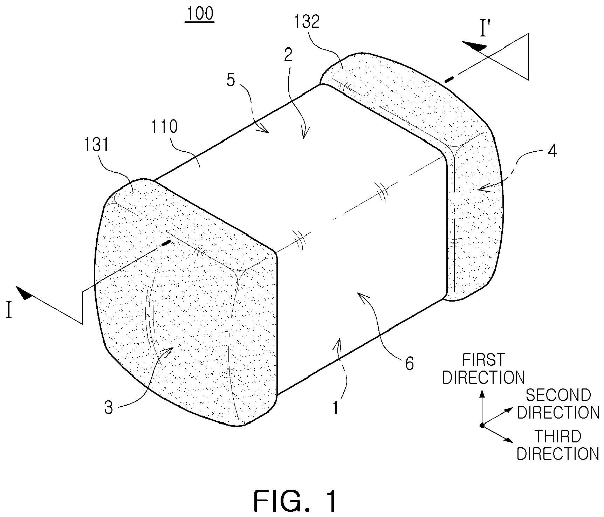

FIG. 1 schematically illustrates a perspective view of a multilayer electronic component according to an exemplary embodiment.

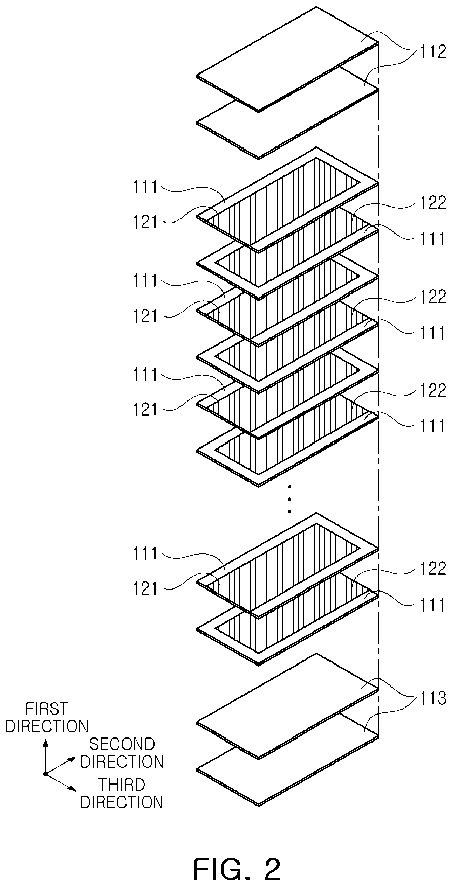

FIG. 2 is an exploded perspective view schematically illustrating a stack structure of internal electrodes in FIG. 1.

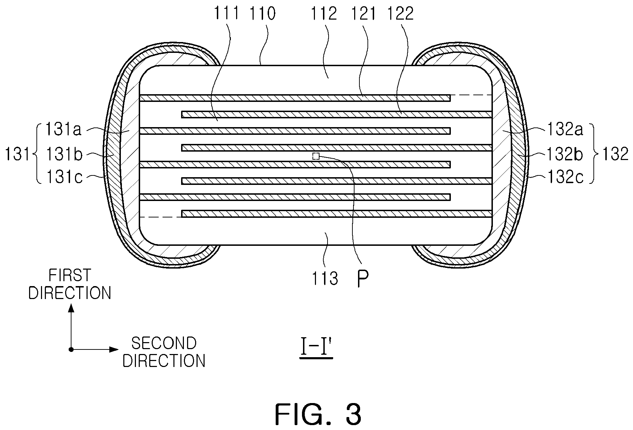

FIG. 3 is a cross-sectional view taken along line I-I' of FIG. 1.

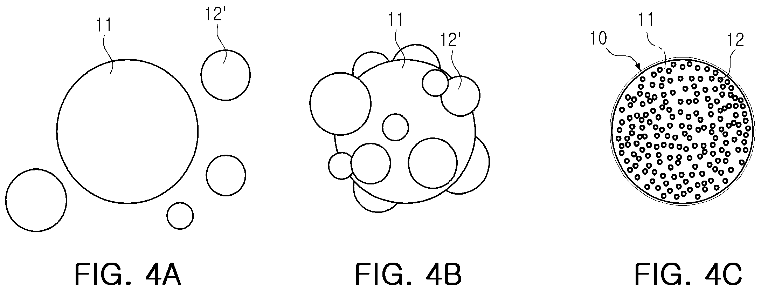

FIGS. 4A to 4C schematically illustrate dielectric powder particles of Comparative Examples and Inventive Examples.

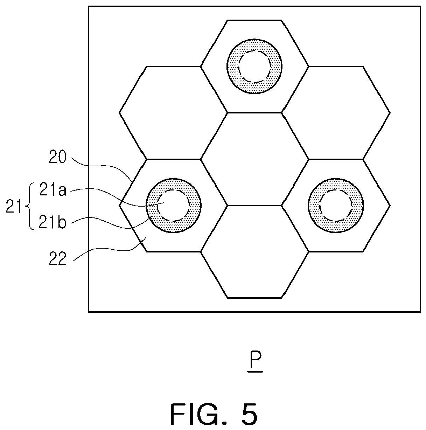

FIG. 5 is a diagram schematically illustrating area P of FIG. 3.

Hereinafter, a multilayer electronic component according to an exemplary embodiment of the present disclosure will be described with reference to FIGS. 1 to 5. However, a multilayer ceramic capacitor is described as an example of a multilayer electronic component, but the present disclosure may be applied to various electronic products using a dielectric composition, such as inductors, piezoelectric elements, varistors, or thermistors.

A multilayer electronic component 100 according to an exemplary embodiment of the present disclosure includes: a body including a dielectric layer 111 and internal electrodes 121 and 122; and external electrodes 131 and 132 disposed outside the body 110 and connected to the internal electrodes 121 and 122, in which the dielectric layer 111 may include a plurality of dielectric crystal grains 20, and at least one of the plurality of dielectric crystal grains 20 may include a core-shell structure including an inner core area 21 and a shell area 22 covering at least a portion of the core area 21, and 90% or more of the plurality of dielectric crystal grains 20 may satisfy an average size of 170.0 nm to 190.0 nm, and a maximum deviation of sizes of the dielectric crystal grains 20 may satisfy ± 60.0 nm compared to an average size of the dielectric crystal grains 20.

The body 110 may include the dielectric layer 111 and the internal electrodes 121 and 122 alternately stacked therein.

More specifically, the body 110 may include a capacitance forming part that includes a first internal electrode 121 and a second internal electrode 122 disposed inside the body 110 and alternately disposed to oppose each other with the dielectric layer 111 interposed therebetween and forms capacitance.

A shape of the body 110 may not be particularly limited, but may be a hexahedral shape or a shape similar to the hexahedral shape, as illustrated in FIG. 1. Although the body 110 does not have a hexahedral shape having perfectly straight lines due to contraction of ceramic powder particles included in the body 110 in a firing process, the body 110 may have a substantially hexahedral shape.

The body 110 may have first and second surfaces 1 and 2 opposing each other in a first direction, third and fourth surfaces 3 and 4 connected to the first and second surfaces 1 and 2 and opposing each other in a second direction, and fifth and sixth surfaces 5 and 6 connected to the first to fourth surfaces 1, 2, 3, and 4 and opposing each other in a third direction.

The plurality of dielectric layers 111 forming the body 110 may be in a fired state, and adjacent dielectric layers 111 may be integrated with each other so that boundaries therebetween may not be readily apparent without using a scanning electron microscope (SEM).

A raw material for forming the dielectric layer 111 is not limited as long as sufficient capacitance may be obtained. Generally, a perovskite (ABO₃)-based material may be used, and for example, a barium titanate-based material, a lead composite perovskite-based material, a strontium titanate-based material, or the like may be used. The barium titanate-based material may include BaTiO₃-based ceramic powder, and examples of the ceramic powder may include BaTiO₃, (Ba₁₋ₓCaₓ)TiO₃ (0<x,1), Ba(Ti_{1-y}Ca_{y})O₃ (0<y<1), (Ba₁₋ₓCaₓ)(Ti_{1-y}Zr_{y})O₃ (0<x<1, 0<y<1), and Ba(Ti_{1-y}Zr_{y})O₃ (0<y<1) in which calcium (Ca), zirconium (Zr), or the like is partially dissolved in the BaTiO₃, or the like.

In addition, a raw material of the dielectric layer 111 may be prepared by adding various ceramic additives, organic solvents, binders, dispersants, and the like, to powder particles such as the barium titanate (BaTiO₃) powder, according to an object of the present disclosure.

A thickness of the dielectric layer 111 does not need to be particularly limited.

Although the dielectric layer 111 with a thickness of several µm may be manufactured for required dielectric characteristics, the thickness of the dielectric layer may be 0.6 µm or less, and more preferably 0.4 µm or less, in order to more easily achieve miniaturization and high capacity of the multilayer electronic component.

Here, the thickness of the dielectric layer 111 may mean the thickness of the dielectric layer 111 disposed between the first and second internal electrodes 121 and 122.

Meanwhile, the thickness of the dielectric layer 111 may mean the size of the dielectric layer 111 in the first direction. Also, the thickness of the dielectric layer 111 may mean the average thickness of the dielectric layer 111 and may mean the average size of the dielectric layer 111 in the first direction.

The average size of the dielectric layer 111 in the first direction may be measured by scanning images of cross-sections of the body 110 in the first and second directions with a scanning electron microscope (SEM) at a magnification of 10,000. More specifically, it may be an average value obtained by measuring the size of one dielectric layer 111 in the first direction at 30 points at equal intervals in the second direction in the scanned image. The 30 points at equal intervals may be designated in the capacitance forming part. In addition, when the size measurement in the first direction is extended to 10 dielectric layers 111 and the average value is measured, the average size of the dielectric layer 111 in the first direction may be further generalized.

Meanwhile, the multilayer ceramic capacitor, which is a type of multilayer electronic component, may operate in various operating environments. Some of these environments may adversely affect multilayer electronic components, resulting in deterioration in reliability such as short life expectancy or lack of target electrical characteristics. For this reason, achieving high reliability of the multilayer electronic components is treated as one of the important tasks, and as one of the methods for improving reliability, there is a method of forming dielectric crystal grains having a uniform size. However, dielectric powder and additive particles need to be uniformly dispersed to implement dielectric crystal grains having a uniform size. To this end, various methods such as using an organic dispersant in an organic solvent or adding dielectric powder to an additive have been tried.

In this case, among the methods of improving reliability by controlling the type and content of additives, there are various methods such as solid-phase pre-dispersion or solid-phase pre-diffusion in which additives are added in the form of oxide. However, the existing methods such as the solid-phase pre-dispersion or the solid-phase pre-diffusion have poor dispersibility or have limitations in forming a uniform coating layer, and thus, have some limitations in producing the dielectric powder and dielectric crystal grains having a uniform size and have parts that need improvement in terms of a production process or economics.

Therefore, in the present disclosure, by coating a surface of dielectric particles with an additive element material liquefied in an ionic state in a water system so that the average size and size dispersion of the dielectric crystal grains may be improved after final sintering, various advantages that may solve the above-described problems may exist. The additive element materials in the ionic state are smaller in size than the general oxidizer type, so a surface coating coverage ratio of the dielectric particles is high and a thickness of the coating layer is also thin. In addition, it is possible to uniformly control the average size of particles after final sintering by suppressing a necking phenomenon between dielectric particles during the sintering process. These results have the effect of contributing to the overall reliability characteristics and dispersion improvement effect.

Meanwhile, in the case of coating the additive element material liquefied in the ionic state, when an organic solvent is used or two or more solvents are mixed and used, there are problems in that the ionic state may become unstable and are economically unfavorable such as requiring an additional washing process. On the other hand, when the ionic additive elemental material is applied in a single aqueous solvent, the dispersibility of the additive may be excellent, the mass production may be easy, and the ion additive may be stably adsorbed on the dielectric particles, so it is possible to effectively control the growth inhibition of crystal grains.

FIGS. 4A to 4C schematically illustrate a state in which additives 12 and 12' are added to a pre-firing dielectric particle 11. More specifically, FIG. 4A illustrates a solid-phase pre-dispersion state, FIG. 4B illustrates a solid-phase pre-diffusion state, and FIG. 4C illustrates a liquid-phase pre-diffusion state.

In the present disclosure, the dielectric particle 11 may mean a particle or powder state of a pre-firing dielectric material that may contribute to the above-described dielectric capacitance, the additives 12 and 12' may mean a pre-firing material capable of controlling various characteristics of the dielectric material, and the dielectric composition 10 may mean a pre-firing state in which the additives 12 and 12' are coated or adsorbed on the dielectric particle 11.

In the case of the solid-phase pre-dispersion as illustrated in FIG. 4A, since the additives are added to a solvent including organic matters in the form of the oxide, it is difficult to implement a uniform dispersion state of the additive component, and even if the additive oxide and the solvent are stirred, the bonding force between the additive oxide 12' and the dielectric particle 11 is weak, and thus, the adsorption does not sufficiently occur, or even if the adsorption occurs, the additive oxide 12' and the dielectric particle 11 may be easily separated. Accordingly, since the grain growth of the dielectric particles 11 is not sufficiently controlled by the additive oxide 12' , it is difficult to control the dielectric crystal grains to obtain the dielectric crystal grains having a uniform size, so the size dispersion of the crystal grains may be high.

In the case of the solid-phase pre-diffusion as illustrated in FIG. 4B, the additive 12' is added to the solvent including the organic matters in the form of the oxide, and then adsorbed and dissolved into the dielectric particle 11 to produce a dielectric composition in which the dielectric particles 11 grow into grains. The adsorption and the solid solution of the additive 12' is easier than in the case of the solid-phase pre-dispersion, but since the additive 12' is adsorbed in the form of the oxide, a ratio of the relatively large-sized additive 12' covering the dielectric particles 11 may be low, and similarly, it is difficult to control to obtain the dielectric crystal grains having a uniform size, and thus, the size dispersion of the crystal grains may be relatively high.

In the case of the liquid-phase pre-diffusion as illustrated in FIG. 4C for producing an exemplary embodiment of the present disclosure, the additive 12 may be atomized in an ionic state in a single aqueous solvent and uniformly adsorbed on the surface of the dielectric particle 11. By the additive 12 atomized in the ionic state, the dispersibility of the additive material may be maximized compared to the form of the conventional additive oxide 12', and the additive ions 12 atomized in an ionic state may be uniformly coated on the surface of the dielectric particles 11 to minimize a contact between the dielectric particles 11 during the sintering process, thereby creating an environment capable of controlling the grain growth of the crystal grains and contributing to the size distribution and the improvement in reliability characteristics. In addition, since the method that may be applied to the single aqueous solvent may be used, the method may be suitable for process application for mass production and may be economically advantageous.

Hereinafter, the exemplary embodiment of the present disclosure including the dielectric crystal grain 20 obtained by firing the dielectric composition 10 in which the surface of the dielectric particle 11 is coated with the additive 12 by the liquid-phase pre-diffusion method will be described in detail.

In the multilayer electronic component 100 according to the exemplary embodiment of the present disclosure, the dielectric layer 111 may include the plurality of dielectric crystal grains 20, at least one of the plurality of dielectric crystal grains 20 may include a core-shell structure including an inner core area 21 and a shell area 22 covering at least a portion of the core area 21, 90% or more of the plurality of dielectric crystal grains 20 may satisfy an average size of 170.0 nm to 190.0 nm, and a maximum deviation of sizes of the dielectric crystal grain 20 may satisfy ± 60.0 nm compared to an average size of the dielectric crystal grains 20. Here, 90% or more may mean D90 according to the cumulative distribution.

In an exemplary embodiment of the present disclosure, the dielectric layer 111 may include a main component of a base material and a sub-component including rare earth elements.

Here, the main component of the base material may mean a dielectric material that is a raw material for forming dielectric capacitance, and the main component may mean a component that occupies a relatively large weight ratio compared to other components, and mean a component that is at least 50% by weight based on the weight of the entire composition or dielectric layer. The dielectric material that may be a raw material is the same as described above, and therefore, a description thereof will be omitted.

The sub-component may mean a component that occupies a relatively small weight ratio compared to other components, and may mean a component that is less than 50% by weight based on the weight of the entire composition or dielectric layer.

In this case, the sub-component may include rare earth element including one or more selected from La, Y, Ac, Ce, Pr, Nd, Pm, Sm, Eu, Gd, Tb, Dy, Ho, Er, Tm, Yb, and Lu, or is not particularly limited thereto.

An average content of the rare earth elements may be higher in the shell 22 area than in the core 21 area.

A criterion for dividing the core area 21 and the shell 22 area may be as follows. When a line-profile is performed on a straight line passing through the center point of the dielectric crystal grains 20, a rapid change in the content of the rare earth elements may occur at an arbitrary point inside the dielectric crystal grain 20. Based on the center of the area where the rapid change occurs, the area where the content of the rare earth elements is low may be defined as the core 21 area, and the area where the content of the rare earth elements is high may be defined as the shell 22 area.

Referring to FIG. 5, the dielectric layer 111 may include the plurality of dielectric crystal grains 20, and at least one of the plurality of dielectric crystal grains 20 may have the core-shell structure that includes the inner core area 21 and the shell area 22 covering at least a portion of the core area 21.

In the present disclosure, the size of the dielectric crystal grains may mean the average size of the minimum and maximum diameters passing through the center point of the dielectric crystal grains, and the average size of the dielectric crystal grains 20 may be a value obtained by averaging the sizes of the dielectric crystal grains present in the dielectric layer 111.

In an exemplary embodiment of the present disclosure, 90% or more of the plurality of dielectric crystal grains 20 satisfy the average size of 170.0 nm or more and 190.0 nm or less, and the maximum deviation of the sizes of the dielectric crystal grains 20 may satisfy ±60.0 nm compared to the average size of the dielectric crystal grains 20.

The average size of the dielectric crystal grains 20 may mean the average size of the plurality of measurable dielectric crystal grains 20 within the dielectric layer 111, the maximum deviation may mean the maximum and minimum size ranges of the measurable dielectric crystal grains 20, and the exemplary embodiment of the present disclosure may mean that the maximum deviation satisfies within a range of 160.0 nm based on the average size of the dielectric crystal grains 20.

In an exemplary embodiment of the present disclosure, the coefficient of variation (CV), which is the ratio of the standard deviation value of the sizes of the dielectric crystal grains 20 to the average size of the dielectric crystal grains 20, may satisfy less than 30%.

The coefficient of variation (CV) means the standard deviation compared to the average. The coefficient of variation of the size of the dielectric crystal grain 20 may mean the ratio of the standard deviation value of the average size of the dielectric crystal grains 20 to the size of the dielectric crystal grains 20, and the lower value of the coefficient of variation (CV) may mean that the dielectric crystal grain 20 has a uniform size and the size dispersion is narrow.

In other words, the fact that the coefficient of variation (CV) of the size of the dielectric crystal grain 20 is less than 30% may mean that the size dispersion of the dielectric crystal grains 20 is narrow, and may mean that there is not much difference in size based on the average size.

The lower limit of the coefficient of variation (CV) is not particularly limited, but since it may be difficult to form an absolutely identical size, it may preferably satisfy 0.01% or more.

Since the dielectric crystal grains 20 have a uniform size, it may contribute to improving the characteristic distribution and reliability of the multilayer electronic component 100.

As described above, when the additive, for example, the rare earth elements are added in a solid phase method, there may be a limit to the uniform dispersion of the rare earth elements, which may cause the difference in the content of the rare earth elements for each part. As a result, the characteristic dispersion may increase, and thus, problems such as difficulty in controlling the characteristics to be implemented may occur. As such, the uniform formation of the core-shell structure in the fine-sized dielectric crystal grains is regarded as an important challenge to improve electrical characteristics, dielectric properties, and reliability.

In an exemplary embodiment of the present disclosure, the core area 21 may include rare earth elements.

More specifically, referring to FIG. 5 schematically showing the dielectric crystal grain 20 including the core-shell structure, when, in the core area 21, an area from the center point of the core area 21 to a 1/2 point of the core area 21 outward is defined as a first core area 21a, and an area from the 1/2 point of the core area 21 to an outer boundary of the core area 21 is defined as a second core area 21b, the first core area 21a may include rare earth elements.

Here, the center point of the core area 21 may coincide with the center point of the dielectric crystal grains 20, and the outer direction from the center point of the core area 21 may mean a direction in which the shell area 22 or the dielectric crystal grain system exists from the center point of the core area 21. The 1/2 point may mean a point corresponding to 1/2 when a straight line is drawn from the center point of the core area 21 to a boundary point where the core area 21 and the shell area 22 come into contact. The outer portion of the core area 21 may mean a boundary line or boundary surface where the core area 21 and the shell area 22 come into contact, and as described above, the boundary may mean the center of the area in which the content of the rare earth elements rapidly change when the line-profile is performed. An outer portion of the core area 21 may be the same as that of the second core area 21b.

In this case, the average content of the rare earth elements included in the first core area 21a may satisfy more than 0.00 at% and less than 0.20 at%. Here, it is sufficient as long as the content of the rare earth elements is included only in a small amount, but the average content of the rare earth elements may preferably satisfy 0.01 at% or more.

More specifically, the average content of the rare earth elements included in the area from the center point of the core area 21 to 1/2 point of the first core area 21a may satisfy greater than 0.00 at% and less than or equal to 0.05 at%, and the content of the rare earth elements at the central point of the core area 21 may satisfy greater than 0.00 at% and less than or equal to 0.05 at%.

By satisfying this, it may be inferred that the rare earth elements are diffused into the core area 21 and that the dielectric powder 10 is formed in the liquid-phase pre-diffusion method, and the dielectric crystal grains 20 having the small shell area 22b may be formed as electrical characteristics are improved.

The average content of the rare earth elements included in the second core area 21b may be higher than the average content of the rare earth elements included in the first core area 21a and lower than the average content of the rare earth elements included in the shell area 22b.

In addition, as some of the rare earth elements are diffused into the core area 21, the dielectric crystal grains 20 having a relatively large size in the core area 21 may be formed in the fine-sized dielectric crystal grains 20, so the electrical and dielectric characteristics may be improved. In addition, as the size dispersion of the dielectric crystal grains 20 becomes uniform, the reliability may be improved.

In an exemplary embodiment of the present disclosure, when the area in which the average content of the rare earth elements in the core area 21 is greater than 0.00 at% and less than 0.20 at% is defined as the first area 21a, the second core area 21b may mean an area covering at least a part of the first core area. In this case, the average content of the rare earth elements included in the second core area 21b may be higher than the average content of the rare earth elements included in the first core area 21a and lower than the average content of the rare earth elements included in the shell area 22.

The method of measuring the rare earth elements in the core area 21 is not particularly limited. For example, the content of the rare earth elements may be measured by measuring the line-profile, and in the first core area 21a having a very small content of rare earth elements, when the measurement by the line-profile is not possible, by performing EDS analysis at one point, the content of rare earth elements in minute amounts may be measured.

The internal electrodes 121 and 122 may be alternately stacked with the dielectric layer 111.

The internal electrodes 121 and 122 may include a first internal electrode 121 and a second internal electrode 122, and the first and second internal electrodes 121 and 122 may be alternately disposed to oppose each other with the dielectric layer 111 constituting the body 110 interposed therebetween, and may be exposed to third and fourth surfaces 3 and 4 of the body 110, respectively.

More specifically, the first internal electrode 121 may be spaced apart from the fourth surface 4 and exposed through the third surface 3, and the second internal electrode 122 may be spaced apart from the third surface 3 and exposed through the four sides 4.

The first external electrode 131 may be disposed on the third surface 3 of the body 110 and connected to the first internal electrode 121, and the second external electrode 132 may be disposed on the fourth surface 4 of the body 110 and connected to the second internal electrode 122.

That is, the first internal electrode 121 may not be connected to the second external electrode 132, but may be connected to the first external electrode 131, and the second internal electrode 122 may not be connected to the first external electrode 131 and may be connected to the second external electrode 132. In this case, the first and second internal electrodes 121 and 122 may be electrically insulated from each other by the dielectric layer 111 disposed therebetween.

Meanwhile, the body 110 may be formed by alternately stacking a ceramic green sheet on which the first internal electrode 121 is printed and a ceramic green sheet on which the second internal electrode 122 is printed, and then firing the ceramic green sheet.

The material for forming the internal electrodes 121 and 122 may not be particularly limited, and a material having excellent electrical conductivity may be used. For example, the internal electrodes 121 and 122 may include at least one of nickel (Ni), copper (Cu), palladium (Pd), silver (Ag), gold (Au), platinum (Pt), tin (Sn), tungsten (W), titanium (Ti), and alloys thereof.

In addition, the internal electrodes 121 and 122 may be formed by printing, on a ceramic green sheet, a conductive paste for the internal electrode that includes at least one of nickel (Ni), copper (Cu), palladium (Pd), silver (Ag), gold (Au), platinum (Pt), tin (Sn), tungsten (W), titanium (Ti), and alloys thereof. A method of printing a conductive paste for the internal electrode may be a screen printing method, a gravure printing method, or the like, but the present disclosure is not limited thereto.

Meanwhile, the thickness of the internal electrodes 121 and 122 does not need to be particularly limited.

Although the internal electrodes 121 and 122 having a thickness of several µm may be manufactured for required electrical characteristics, the thickness of the internal electrodes 121 and 122 may be 0.6 µm or less, and more preferably 0.4 µm or less, in order to more easily achieve the miniaturization and high capacity of the multilayer electronic component.

Here, the thickness of the internal electrodes 121 and 122 may mean the sizes of the internal electrodes 121 and 122 in the first direction. Also, the thickness of the internal electrodes 121 and 122 may mean the average thickness of the internal electrodes 121 and 122 and may mean the average size of the internal electrodes 121 and 122 in the first direction.

The average size of the internal electrodes 121 and 122 in the first direction may be measured by scanning images of cross-sections of the body 110 in the first and second directions with a scanning electron microscope (SEM) at a magnification of 10,000. More specifically, it may be an average value obtained by measuring the size of one of the internal electrodes 121 and 122 in the first direction at 30 points at equal intervals in the second direction in the scanned image. The 30 points at equal intervals may be designated in the capacitance forming part. In addition, when the average value is measured by extending the average value measurement to 10 internal electrodes 121 and 122, the average size of the internal electrodes 121 and 122 in the first direction may be further generalized.

Meanwhile, the body 110 may include cover parts 112 and 113 disposed on both end-surfaces of the capacitance forming part in the first direction.

More specifically, the body 110 may include an upper cover part 112 disposed above the capacitance forming part in the first direction and a lower cover part 113 disposed below the capacitance forming part in the first direction.

The upper cover part 112 and the lower cover part 113 may be formed by stacking a single dielectric layer 111 or two or more dielectric layers 111 on upper and lower surfaces of the capacitance forming part, respectively, in the first direction, and may basically serve to prevent damage to the internal electrodes 121 and 122 due to physical or chemical stress.

The upper cover portion 112 and the lower cover portion 113 do not include the internal electrodes 121 and 122 and may include the same material as the dielectric layer 111. That is, the upper and lower cover portions 112 and 113 may include a ceramic material such as a barium titanate (BaTiO₃)-based ceramic material.

Meanwhile, the thickness of the cover parts 112 and 113 does not need to be particularly limited.

However, in order to more easily achieve the miniaturization and high capacity of the multilayer electronic component, the thickness of the cover parts 112 and 113 may be 100 µm or less, preferably 30 µm or less, and more preferably 20 µm or less for micro-miniature products.

Here, the thickness of the cover parts 112 and 113 may mean the size of the cover parts 112 and 113 in the first direction. Also, the thickness of the cover parts 112 and 113 may mean the average thickness of the cover parts 112 and 113 and may mean the average size of the cover parts 112 and 113 in the first direction.

The average size of the cover parts 112 and 113 in the first direction may be measured by scanning images of cross-sections of the body 110 in the first and second directions with a scanning electron microscope (SEM) at a magnification of 10,000. More specifically, it may be an average value obtained by measuring the size of one cover part in the first direction at 30 points at equal intervals in the second direction in the scanned image. The 30 points at equal intervals may be designated in the cover part 112. In addition, when the average value is measured by extending the average value measurement to the lower cover part 113, the average size of the cover parts 112 and 113 in the first direction may be further generalized.

Meanwhile, the body 110 may include a side margin part disposed on both end-surfaces of the capacitance forming part in the third direction.

More specifically, the side margin part may include a first side margin part disposed on a fifth surface 5 of the capacitance forming part and a second side margin part disposed on a sixth surface 6 of the capacitance forming part. That is, the side margin part may be disposed on both end-surfaces of the capacitance forming part in the third direction.

As illustrated in the drawing, based on the cross-sections of the body 110 in the first and third directions, the side margin part may mean an area between both end-surfaces of the first and second internal electrodes 121 and 122 in the third direction and a boundary surface of the body 110.

The internal electrodes 121 and 122 may be formed on the side margin part by applying a conductive paste on the ceramic green sheet, except where the side margin portion is to be formed, and in order to suppress a step difference caused by the internal electrodes 121 and 122, after the stacked internal electrodes 121 and 122 are cut to expose the fifth and sixth surfaces 5 and 6 of the body 110, the single dielectric layer 111 or two or more dielectric layers 111 may be stacked in a third direction on both end-surfaces of the capacitance forming part in the third direction.

The side margin parts 114 and 115 may basically serve to prevent damage to the internal electrodes 121 and 122 due to physical or chemical stress.

Meanwhile, the width of the side margin part does not need to be particularly limited.

However, in order to more easily achieve the miniaturization and high capacity of the multilayer electronic component 100, the width of the side margin part may be 100 µm or less, preferably 30 µm or less, and more preferably 20 µm or less for micro-miniature products.

Here, the width of the side margin part may mean the size of the side margin part in the third direction. Also, the width of the side margin part may mean the average width of the side margin parts 114 and 115, and may mean the average size of the side margin part in the third direction.

The average size of the side margin part in the third direction may be measured by scanning images of cross-sections of the body 110 in the first and third directions with a scanning electron microscope (SEM) at a magnification of 10,000. More specifically, it may be an average value obtained by measuring the size of one side margin part in the third direction at 30 points at equal intervals in the first direction in the scanned image. The 30 points at equal intervals may be designated in the first side margin part. In addition, when the average value is measured by extending the average value measurement to the second side margin part, the average size of the side margin part in the third direction may be further generalized.

The exemplary embodiment of the present disclosure describes the structure in which the ceramic electronic component 100 has two external electrodes 131 and 132, but the number, shapes, or the like, of external electrodes 131 and 132 may be changed depending on the shapes of the internal electrodes 121 and 122 or other purposes.

The external electrodes 131 and 132 may be disposed on the body 110, and may be connected to the internal electrodes 121 and 122.

More specifically, the external electrodes 131 and 132 may be disposed on the third and fourth surfaces 3 and 4 of the body 110, respectively, and may include the first and second external electrodes 131 and 132 connected to the first and second internal electrodes 121 and 122, respectively. That is, the first external electrode 131 may be disposed on the third surface 3 of the body and connected to the first internal electrode 121, and the second external electrode 132 may be disposed on the fourth surface 4 of the body and connected to the second internal electrode 122.

Meanwhile, the external electrodes 131 and 132 may be formed of any material having electrical conductivity, such as a metal, or the like, a certain material of each of the external electrodes 131 and 132 may be determined in consideration of electrical characteristics, structural stability, or the like, and the external electrodes 131 and 132 may have a multilayer structure.

For example, the external electrodes 131 and 132 may include electrode layers 131a, 132a, 131b, and 132b disposed on the body 110 and plating layers 131c and 132c disposed on the electrode layers 131a, 132a, 131b, and 132b, but is not particularly limited thereto.

For more specific examples of the electrode layers 131a, 132a, 131b, and 132b, the electrode layers may be fired electrodes made of conductive metal and glass or resin-based electrodes made of conductive metal and a resin.

In addition, the electrode layer may have a form in which the fired electrode and the resin-based electrode are sequentially formed on the body.

Also, the electrode layer may be formed by transferring a sheet including conductive metal onto the body or by transferring a sheet including conductive metal onto a fired electrode.

Materials with excellent electrical conductivity may be used as the conductive metal included in the electrode layer. For example, the conductive metal may include one or more selected from the group consisting of nickel (Ni), copper (Cu), palladium (Pd), silver (Ag), gold (Au), platinum (Pt), tin (Sn), tungsten (W), titanium (Ti), and alloys thereof, but is not particularly limited thereto.

In an exemplary embodiment of the present disclosure, the electrode layers 131a, 132a, 131b, and 132b may have a two-layer structure including the first electrode layers 131a and 132a and the second electrode layers 131b and 132b.

The first electrode layers 131a and 132a may be disposed on the body 110 and may include first conductive metal and glass, and the second electrode layers 131b and 132b may be disposed on the first electrode layers 131a and 132a and include second conductive metal and a resin.

As the first electrode layers 131a and 132a include glass, the first electrode layers 131a and 132a may serve to improve a bonding property with the body 110, and as the second electrode layers 131b and 132b include a resin, the second electrode layers 131b and 132b may serve to improve bending strength.

Meanwhile, the first conductive metal and the second conductive metal may include the above-described conductive metal, and may include the same material or different materials.

More specifically, the first conductive metal used in the first electrode layers 131a and 132a is not particularly limited as long as it is a material that may be electrically connected to the internal electrodes 121 and 122 to form the capacitance. For example, the first conductive metal may include one or more selected from the group consisting of nickel (Ni), copper (Cu), palladium (Pd), silver (Ag), gold (Au), platinum (Pt), tin (Sn), tungsten (W), titanium (Ti), and alloys thereof. The first electrode layers 131a and 132a may be formed by applying and then sintering a conductive paste prepared by adding glass frit to conductive metal powder particles.

The second conductive metal included in the second electrode layers 131b and 132b may serve to be electrically connected to the first electrode layers 131a and 132a.

The conductive metal included in the second electrode layers 131b and 132b is not particularly limited as long as it is a material that may be electrically connected to the electrode layers 131a and 132a, and may include one or more selected from the group consisting of nickel (Ni), copper (Cu), palladium (Pd), silver (Ag), gold (Au), platinum (Pt), tin (Sn), tungsten (W), titanium (Ti), and alloys thereof.

The second conductive metal included in the second electrode layers 131b and 132b may include at least one of spherical particles and flake particles. That is, the conductive metal may consist of only flake-shaped particles or only spherical particles, or may be a mixture of the flake-shaped particles and the spherical particles. Here, the spherical particles may include a shape that is not perfectly spherical, and may include a shape in which, for example, a length ratio (major axis/minor axis) between a major axis and a minor axis is 1.45 or less. The flake-shaped particles mean particles having a flat and elongated shape, and are not particularly limited, but, for example, the length ratio (major axis/minor axis) between the major axis and the minor axis may be 1.95 or more. The lengths of the major and minor axes of the spherical particles and the flake-shaped particles may be measured from images obtained by scanning the cross-sections in the first and second directions cut from the central portion of the ceramic electronic component in the third direction with the scanning electron microscope (SEM).

The resin included in the second electrode layers 131b and 132b serves to secure a bonding property and absorb shock. The resin included in the second electrode layers 131b and 132b may have a bonding property and a shock absorbing property, may be any resin that may be mixed with conductive metal powder particles to form a paste, and may include, for example, an epoxy-based resin.

In addition, the second electrode layers 131b and 132b may include a plurality of metal particles, an intermetallic compound, and a resin. As the intermetallic compound is included, electrical connectivity with the first electrode layers 131a and 132a may be further improved. The intermetallic compound serves to improve electrical connectivity by connecting a plurality of metal particles, and may serve to surround and connect the plurality of metal particles to each other.

In this case, the intermetallic compound may include a metal having a melting point lower than the curing temperature of the resin. That is, since the intermetallic compound includes a metal having a melting point lower than the curing temperature of the resin, the metal having a melting point lower than the curing temperature of the resin may be melted during the drying and curing process, and form the intermetallic compound with a portion of the metal particle to surround the metal particle. In this case, the intermetallic compound may preferably include a metal having a low melting point of 300°C or less.

For example, the intermetallic compound may include Sn having a melting point of 213 to 220°C. During the drying and curing process, Sn is melted, and the molten Sn wets high-melting-point metal particles such as Ag, Ni, or Cu by a capillary phenomenon, and reacts with some of the Ag, Ni, or Cu metal particles to form intermetallic compounds such as Ag₃Sn, Ni₃Sn₄, Cu₆Sn₅, and Cu₃Sn. Ag, Ni, or Cu that did not participate in the reaction remains in the form of metal particles.

Accordingly, the plurality of metal particles may include one or more of Ag, Ni, and Cu, and the intermetallic compound may include one or more of Ag₃Sn, Ni₃Sn₄, Cu₆Sn₅, and Cu₃Sn.

The plating layers 131c, 132c, 131d, and 132d serve to improve mounting characteristics.

The type of metal of the plating layer is not particularly limited, and may be a single plating layer including one or more of nickel (Ni), tin (Sn), palladium (Pd), and alloys thereof, or may be formed of a plurality of layers.

In this case, the plating layer may be disposed on the electrode layer and include first plating layers 131c and 132c including the first plating metal, and second plating layers 131d and 132d that are disposed on the first plating layers 131c and 132c and include the second plating metal.

Here, the first plating metal and the second plating metal may be metal types of the plating layer described above, and may include the same material or different materials.

For a more specific example of the plating layer, the plating layer may be a Ni plating layer or a Sn plating layer, and may have a form in which the Ni plating layer and the Sn plating layer are sequentially formed on the electrode layers 131a, 132a, 131b, and 132b, and have a form in which the Sn plating layer, the Ni plating layer, and the Sn plating layer are sequentially formed. In addition, the plating layers 131c and 132c may include the plurality of Ni plating layers and/or the plurality of Sn plating layers.

Although the exemplary embodiments have been described in detail above, the present disclosure may not be limited to the above-described exemplary embodiments and the accompanying drawings, but is intended to be limited to the appended claims. Accordingly, various types of substitutions, modifications and changes will be possible by those of ordinary skill in the art without departing from the present disclosure described in the claims, and belong to the scope of the present disclosure.

Hereinafter, the present disclosure will be described in more detail through Experimental Examples. However, they are to assist in the detailed understanding of the present disclosure, and the scope of the present disclosure is not limited by Inventive Examples.

### (Experimental Example)

In the following Comparative Examples and Inventive Example, dielectric compositions are formed by doping dielectric particles with additive elements in different ways, and dielectric layers including dielectric crystal grains are implemented by firing the dielectric compositions prepared in different ways.

In Comparative Example 1, the dielectric composition was prepared by doping barium titanate (BaTiO₃) with dysprosium (Dy) through a solid-phase pre-dispersion method, and fired to manufacture a sample chip.

Comparative Example 2 is the same as Comparative Example 1 except that barium titanate (BaTiO₃) is doped with Dy through the solid-phase pre-diffusion method.

Inventive Example is the same as Comparative Example 1 except that barium titanate (BaTiO₃) is doped with Dy through the liquid-phase pre-diffusion method.

Table 1 below is data obtained by evaluating electrical characteristics, Dc-bias characteristics, and reliability of Comparative Examples and Inventive Examples.

The electrical characteristics were measured for dielectric capacitance Cp and dissipation factor (DF), and for the Dc-bias characteristics, Cp and DC were measured under a voltage condition of 14V.

The reliability was evaluated by mean time to failure (MTTF). In each Comparative Example and Inventive Example, when the reliability evaluation was performed on 40 sample chips, it means the average time of failure occurrence times for each sample.

In this case, B0.1 means the time at which 0.1% of all the sample chips fail, B0.43 means the time at which 0.4329% of all the sample chips fail, and a shape parameter means the dispersion of the sample failure time and means that the higher the shape parameter value, the lower the initial failure frequency and the higher the failure frequency over time.

**[Table 1]**

| | Electrical Characterist ics | | Dc-bias | | Reliability | | | |
|---|---|---|---|---|---|---|---|---|
| | Cp (µF) | DF | Cp@14V (µF) | DC@14V | MTTF (hrs) | B0.1 (hrs) | B0.43 (hrs) | Shape Paramet er |
| Compara | 10.28 | 0.0493 | 3.29 | -68.2% | 142.65 | 26.30 | 38.40 | 3.86 |
| tive Example 1 | | | | | | | | |
| Compara tive Example 2 | 10.53 | 0.0684 | 3.23 | -69.9% | 165.53 | 9.75 | 18.21 | 2.34 |
| Inventi ve Example | 10.14 | 0.0651 | 3.24 | -69.1% | 161.65 | 67.59 | 82.38 | 7.38 |

Referring to the above Table 1, it can be seen that there is no significant difference in the electrical characteristics and the Dc-bias characteristics in Comparative Examples and Inventive Example, but Inventive Example are superior in reliability.

It is predicted that the reliability is improved as the size of the dielectric crystal grains is uniform due to the uniform grain growth of the dielectric composition.

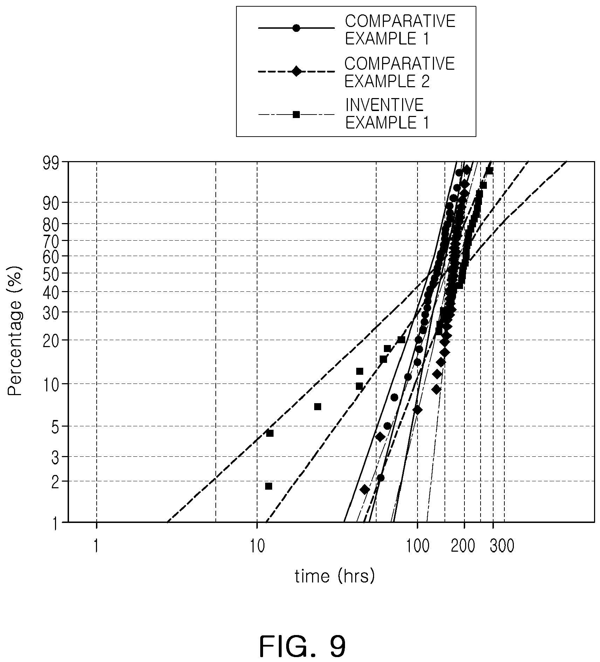

FIG. 9 is a graph cumulatively showing the failure times of the sample chips when the MTTF evaluation of Comparative Example 1, Comparative Example 2, and Inventive Example is performed.

Referring to this, when referring to the fact that Inventive Example took the longest from the sample chip in which the B0.1 and B0.43 values are the smallest in Comparative Example 2 and the largest in Inventive Example until 0.1% of all sample chips fail, it may be confirmed that the reliability of Inventive Example is excellent.

It may be seen from the fact that the shape parameter value is the smallest in Comparative Example 2 and the largest in Inventive Example, and that the distribution of failure times is the widest in Comparative Example 2 and the narrowest in Inventive Example. That is, since the distribution of the failure times is the narrowest in Inventive Example, there is an advantage in that reliability prediction is easy.

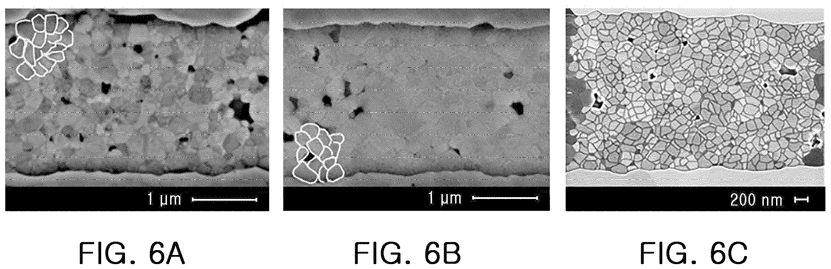

More specifically, describing with reference to drawings, FIGS. 6 to 8 are picture images obtained by mapping the size of the dielectric crystal grain, the size distribution, and the Dy of Comparative Examples and Inventive Example using SEM and SEM-EDS analyzers.

More specifically, FIGS. 6A, 7A, and 8A each relate to Comparative Example 1, FIGS. 6B, 7B to 8B each relate to Comparative Example 2, and FIGS. 6C, 7C, and 8C each relate to Inventive Example.

More specifically, referring to FIG. 6, in Comparative Example 1, the average size of the dielectric crystal grains was 237.7 nm and the maximum deviation was measured as ± 79.5 nm, in Comparative Example 2, the average size of the dielectric crystal grains was 230.0 nm and the maximum deviation was measured as ±72.0 nm, and in Inventive Example, the average size of the dielectric crystal grains was 182.7 nm and the maximum deviation was measured as ±53.1 nm. From this, it may be confirmed that when the dielectric crystal grains are formed through the liquid-phase pre-diffusion, the average size of the dielectric crystal grains may be manufactured with a small uniform size.

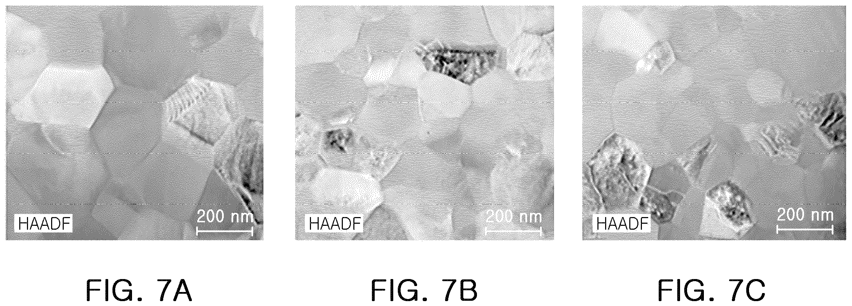

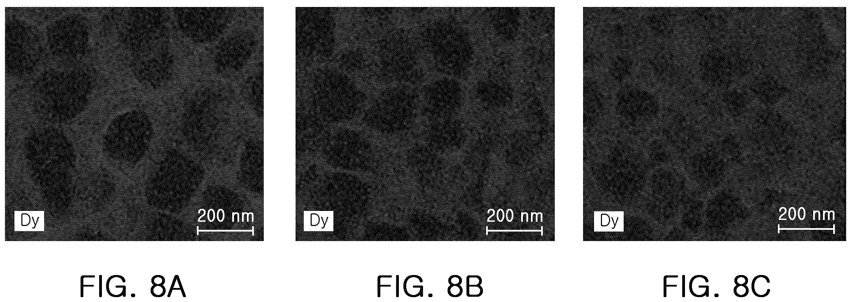

FIGS. 7 and 8 are TEM and TEM-EDS mapping picture image images of the dielectric crystal grains in the same area and their Dy mapping analysis. Referring to FIG. 8C, which is Inventive Example, by comparing FIG. 8a that is Comparative Example 1 with FIG. 8B that is Comparative Example 2, it may be confirmed that the core area is relatively small.

One of various effects of the present disclosure is to uniformly dissolve and diffuse sub-components in dielectric particles as a whole by adding additives in an ionic state, thereby reducing dispersion of electrical characteristics.

One of various effects of the present disclosure is to improve the reliability of a multilayer electronic component by forming dielectric crystal grains having a uniform size.

One of various effects of the present disclosure is to improve electrical characteristics by diffusing sub-components into a core of dielectric crystal grains having a core-shell structure.

However, various and beneficial advantages and effects of the present inventive concept are not limited to the above description, and may be more easily understood in the course of describing the specific embodiments of the present inventive concept.

The term "exemplary embodiment" used herein does not mean the same exemplary embodiment, and is provided to emphasize a particular feature or characteristic different from that of another exemplary embodiment. However, exemplary embodiments provided herein are considered to be able to be implemented by being combined with another exemplary embodiment. For example, even if matters described in a particular exemplary embodiment are not described in another exemplary embodiment, these matters may be understood as a description related to another exemplary embodiment, unless an opposite or contradictory description is provided in another exemplary embodiment.

Terms used herein are used only in order to describe an exemplary embodiment rather than limiting the present disclosure. In this case, singular forms include plural forms unless interpreted otherwise in context.

## Claims

1. A multilayer electronic component, comprising:
a body including a dielectric layer and an internal electrode; and
an external electrode disposed outside the body and connected to the internal electrode,
wherein the dielectric layer includes a plurality of dielectric crystal grains, and at least one of the plurality of dielectric crystal grains includes a core-shell structure including an inner core area and a shell area covering at least a portion of the core area, and
90% or more of the plurality of dielectric crystal grains satisfy an average size of 170.0 nm to 190.0 nm, and a maximum deviation of sizes of the dielectric crystal grains satisfies ± 60.0 nm compared to an average size of the dielectric crystal grains.

2. The multilayer electronic component of claim 1, wherein a coefficient of variation (CV), which is a ratio of a standard deviation value of the sizes of the dielectric crystal grains to the average size of the dielectric crystal grain, satisfies less than 30%.

3. The multilayer electronic component of claim 1, wherein the core area includes a rare earth element.

4. The multilayer electronic component of claim 1, wherein when, in the core area, an area from a center point of the core area to a 1/2 point of the core area outward from the center point is defined as a first core area, and an area from the 1/2 point of the core area to an outer boundary of the core area is defined as a second core area, the first core area includes a rare earth element.

5. The multilayer electronic component of claim 4, wherein an average content of the rare earth element included in the first core area is greater than 0.00 at% and less than 0.20 at%.

6. The multilayer electronic component of claim 4, wherein an average content of the rare earth element included in an area from the center point of the core area to a 1/2 point of the first core area is greater than 0.00 at% and less than or equal to 0.05 at%.

7. The multilayer electronic component of claim 6, wherein an average content of the rare earth element at the center point of the core area is greater than 0.00 at% and less than or equal to 0.05 at%.

8. The multilayer electronic component of claim 3, wherein the shell area includes the rare earth element, the core area includes a first core area in which an average content of the rare earth element satisfies greater than 0.00 at% and less than 0.20 at% and a second core area covering at least a portion of the first core area, and
an average content of the rare earth element included in the second core area is higher than the average content of the rare earth element included in the first core area and lower than an average content of the rare earth element included in the shell area.

9. The multilayer electronic component of claim 1, wherein the dielectric layer includes a main component of base material and a sub-component including a rare earth element, and
an average content of the rare earth element is higher in the shell area than in the core area.

10. The multilayer electronic component of claim 3, wherein the rare earth element includes one or more selected from La, Y, Ac, Ce, Pr, Nd, Pm, Sm, Eu, Gd, Tb, Dy, Ho, Er, Tm, Yb, and Lu.

11. The multilayer electronic component of claim 1, wherein the external electrode includes a first electrode layer that is disposed on the body and includes a first conductive metal and glass, and a second electrode layer that is disposed on the first electrode layer and includes a second conductive metal and a resin.

12. The multilayer electronic component of claim 11, wherein the external electrode further includes a plating layer disposed on the first and second electrode layers.

13. The multilayer electronic component of claim 12, wherein the plating layer includes a first plating layer that is disposed on the first and second electrode layers and includes a first plating metal, and a second plating layer that is disposed on the first plating layer and includes a second plating metal.

14. The multilayer electronic component of claim 1, wherein an average thickness of the dielectric layer is 0.4 µm or less.

15. The multilayer electronic component of claim 1, wherein an average thickness of the internal electrode is 0.4 µm or less.
